# EUROPEAN PATENT APPLICATION

(11) **EP 4 845 026 A1**
(43) Date of publication of application: **25.11.2026**
(21) Application number: 25798263.7
(22) Date of filing: 11.04.2025
(51) Int. Cl.: H03F 1/32, G06N 3/02, H03F 1/02

(54) **ELECTRONIC DEVICE FOR SUPPORTING DIGITAL PRE-DISTORTION, AND OPERATING METHOD THEREOF**

(30) Priority: 30.04.2024 KR 20240058149; 13.09.2024 KR 20240125382
(71) Applicant: Samsung Electronics Co., Ltd., Suwon-si, Gyeonggi-do 16677 (KR)
(72) Inventor: SHIM, Seijoon, Suwon-si Gyeonggi-do 16677 (KR); KIM, Jonghwan, Suwon-si Gyeonggi-do 16677 (KR); CHOI, Chanho, Suwon-si Gyeonggi-do 16677 (KR); HA, Kilsik, Suwon-si Gyeonggi-do 16677 (KR)
(74) Representative: Gulde & Partner
(86) International application number: PCT/KR2025/095199
(87) International publication number: WO 2025/230374

(57) **Abstract**

This electronic device comprises a power amplifier (PA), one or more processors connected to the PA, and a memory for storing instructions. When executed individually or collectively by the one or more processors, the instructions instruct the electronic device to: monitor input data of the PA and output data of the PA; identify a weighted value for a first digital pre-distortion (DPD); identify a hyperparameter for a second DPD on the basis of estimated input data of the PA estimated on the basis of the second DPD based on a neural network (NN) scheme, estimated input data of the PA estimated on the basis of a first DPD, and the input data of the PA; correct, on the basis of the weighted value and the first DPD, first nonlinear data included in the input data of the PA; and correct, on the basis of the hyperparameter and the second DPD, second nonlinear data included in the input data of the PA.

## Description

### [Technical Field]

The disclosure relates generally to electronic devices, and more particularly, to an electronic device supporting digital pre-distortion and an operating method thereof.

### [Background Art]

A communication system has evolved to support a relatively high data rate such as a 5^{th} generation (5G) communication system, to meet the demand for wireless data traffic. For example, the 5G communication system is considered to be implemented on a millimeter wave (mmWave) band (e.g., a 60 gigahertz (GHz) band) to achieve a data rate which is about ten (10) times higher than a data rate of an existing 4^{th} generation (4G) communication system.

In order to support a relatively high data rate, a communication system needs to support a relatively wide bandwidth and/or a relatively high center frequency, and consequently, a power and/or a dynamic range of a radio frequency (RF) component (e.g., a radio frequency front end (RFFE) circuit from among various components for transmitting/receiving signals) may need to be increased. For example, a power amplifier (PA) (e.g., a high power amplifier (HPA)) for amplifying a transmission signal included in the RFFE may need to exhibit a linearity of high output and/or provide a relatively wide range. That is, in a period where a magnitude of an input signal is relatively small, the PA may be able to maintain a linearity of an output signal with respect to the input signal, however, in a period where the magnitude of the input signal is relatively large, the PA may be unable to maintain the linearity of the output signal with respect to the input signal of the PA, and as a result, a non-linear distortion may occur.

In order to compensate for loss of the linearity of the PA (e.g., in order to prevent non-linear distortion from occurring in the PA), a modulator/demodulator (MODEM) may perform a digital pre-distortion (DPD) operation. The MODEM may be implemented as, for example, a processor, a communication processor, and/or an integrated communication processor. The DPD operation may refer to an operation based on a DPD scheme, and the DPD scheme may refer to a scheme for maintaining linearity of a signal outputted from the PA by pre-distorting a signal in order to compensate for a characteristic of a compressed gain of the PA, according to a magnitude of the signal in a digital domain.

A DPD scheme is implemented based on a generalized memory polynomial (GMP) scheme, and/or based on an artificial-intelligence neural network (ANN). However, a DPD scheme based on the GMP scheme may have a relatively high implementation complexity because computation resources, which may be needed to perform the DPD scheme, may increase exponentially depending on a degree of precision of the GMP scheme. Alternatively or additionally, a DPD scheme based on the ANN may need a relatively long time to train the ANN, and as such, it may be difficult to identify an optimal time point for hyperparameters of the ANN.

The above information may be provided as a related art for the purpose of aiding understanding of the disclosure. No claim or determination has been made as to whether any of the foregoing may be applied as a prior art related to the disclosure.

### [Detailed Description of the Invention]

### [Technical Solution]

According to an aspect of the disclosure, an electronic device includes a power amplifier (PA), one or more processors coupled with the PA, and memory storing instructions. The instructions, when executed by the one or more processors individually or collectively, cause the electronic device to monitor, during a set time period, input data of the PA and output data of the PA, identify a weight value for a first digital pre-distortion (DPD) scheme which is based on a generalized memory polynomial (GMP) scheme, based on the input data of the PA and the output data of the PA, identify a hyperparameter for the second DPD scheme, , based on estimated input data of the PA estimated based on a second DPD scheme which is based on a neural network (NN) scheme and estimated input data of the PA estimated based on the first DPD scheme, and the input data of the PA, correct first non-linear data included in the input data of the PA based on the weight value and the first DPD scheme, and correct second non-linear data included in the input data of the PA based on the hyperparameter and the second DPD scheme.

According to an aspect of the disclosure, a method of an electronic device includes monitoring, during a set time period, input data of a PA of the electronic device and output data of the PA, identifying a weight value for a first DPD scheme which is based on a GMP scheme, based on the input data of the PA and the output data of the PA, identifying a hyperparameter for the second DPD scheme, based on estimated input data of the PA estimated based on a second DPD scheme which is based on a neural network (NN) scheme and estimated input data of the PA estimated based on the first DPD scheme, and the input data of the PA, correcting first non-linear data included in the input data of the PA based on the weight value and the first DPD scheme, and correcting second non-linear data included in the input data of the PA based on the hyperparameter and the second DPD scheme.

Additional aspects may be set forth in part in the description which follows and, in part, may be apparent from the description, and/or may be learned by practice of the presented embodiments.

### [Description of the Drawings]

The above and other aspects, features, and advantages of certain embodiments of the present disclosure may be more apparent from the following description taken in conjunction with the accompanying drawings, in which:
FIG. 1 is a block diagram illustrating an electronic device in a network environment, according to an embodiment;
FIG. 2A is a block diagram illustrating an electronic device for supporting a legacy network communication and a 5^{th} generation (5G) network communication, according to an embodiment;
FIG. 2B is a block diagram illustrating an electronic device for supporting a legacy network communication and a 5G network communication, according to an embodiment;
FIG. 3 is a diagram for describing an operation of obtaining an LS solution in a generalized memory polynomial (GMP)-digital pre-distortion (DPD) scheme, according to an embodiment;
FIG. 4 is a block diagram schematically illustrating a DPD processor, according to an embodiment;
FIG. 5 is a flow diagram schematically illustrating an operating process of a DPD processor, according to an embodiment;
FIG. 6 is a signal flow diagram schematically illustrating an operating process of a DPD processor, according to an embodiment; and
FIG. 7 is a flow diagram schematically illustrating an operating process of a DPD processor, according to an embodiment.

### [Mode for Invention]

Hereinafter, example embodiments of the disclosure will be described in detail with reference to the accompanying drawings. In the following description of an embodiment of the disclosure, a detailed description of relevant known functions or configurations incorporated herein may be omitted when it is determined that the description may make the subject matter of an embodiment of the disclosure unnecessarily unclear. The terms which are described below are terms defined in consideration of the functions in the disclosure, and may be different according to users, intentions of the users, or customs. Therefore, the definitions of the terms should be made based on the contents throughout the specification.

It should be noted that the technical terms used herein are only used to describe a specific embodiment, and are not intended to limit an embodiment of the disclosure. Alternatively, the technical terms used herein should be interpreted to have the same meaning as those commonly understood by a person skilled in the art to which the disclosure pertains, and should not be interpreted have excessively comprehensive or excessively restricted meanings unless particularly defined as other meanings. Alternatively, when the technical terms used herein are wrong technical terms that cannot correctly represent the idea of the disclosure, it should be appreciated that they are replaced by technical terms correctly understood by those skilled in the art. Alternatively, the general terms used in an embodiment of the disclosure should be interpreted as defined in dictionaries or interpreted in the context of the relevant part, and should not be interpreted to have excessively restricted meanings.

Alternatively, a singular expression used herein may include a plural expression unless they are definitely different in the context. As used herein, such an expression as "comprises" or "include", or the like should not be interpreted to necessarily include all elements or all operations described in the specification, and should be interpreted to be allowed to exclude some of them or further include additional elements or operations.

Alternatively, the terms including an ordinal number, such as expressions "a first" and "a second", may be used to describe various elements, but the corresponding elements should not be limited by such terms. These terms are used merely to distinguish between one element and any other element. For example, a first element may be termed a second element, and similarly, a second element may be termed a first element without departing from the scope of the disclosure.

It should be understood that when an element is referred to as being "connected" or "coupled" to another element, it may be connected or coupled directly to the other element, or any other element may be interposer between them. In contrast, it should be understood that when an element is referred to as being "directly connected" or "directly coupled" to another element, there are no element interposed between them.

Regardless of drawing signs, the same or like elements are provided with the same reference numeral, and a repeated description thereof may be omitted. Alternatively, in describing an embodiment of the disclosure, a detailed description of relevant known technologies may be omitted when it is determined that the description may make the subject matter of the disclosure unclear. Alternatively, it should be noted that the accompanying drawings are presented merely to help easy understanding of the technical idea of the disclosure, and should not be construed to limit the technical idea of the disclosure. The technical idea of the disclosure should be construed to cover all changes, equivalents, and alternatives, in addition to the drawings.

Hereinafter, an electronic device is described in various embodiments of the disclosure, but the electronic device may be referred to as a terminal, a mobile station, a mobile equipment (ME), a user equipment (UE), a user terminal (UT), a subscriber station (SS), a wireless device, a handheld device, or an access terminal (AT). Alternatively, in an embodiment of the disclosure, the electronic device may be and/or may include a device having a communication function such as, but not limited to, a mobile phone, a personal digital assistant (PDA), a smart phone, a wireless modulator/demodulator (MODEM), a notebook computer, or the like.

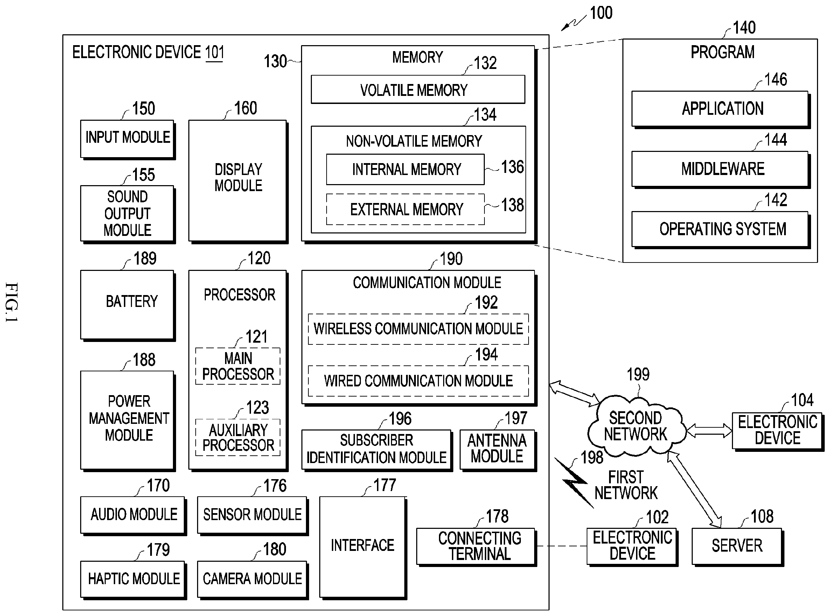

FIG. 1 is a block diagram illustrating an electronic device 101 in a network environment 100, according to an embodiment.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence model is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 millisecond (ms) or less for each of downlink (DL) and uplink (UL), or a round trip of 1 ms or less) for implementing URLLC.

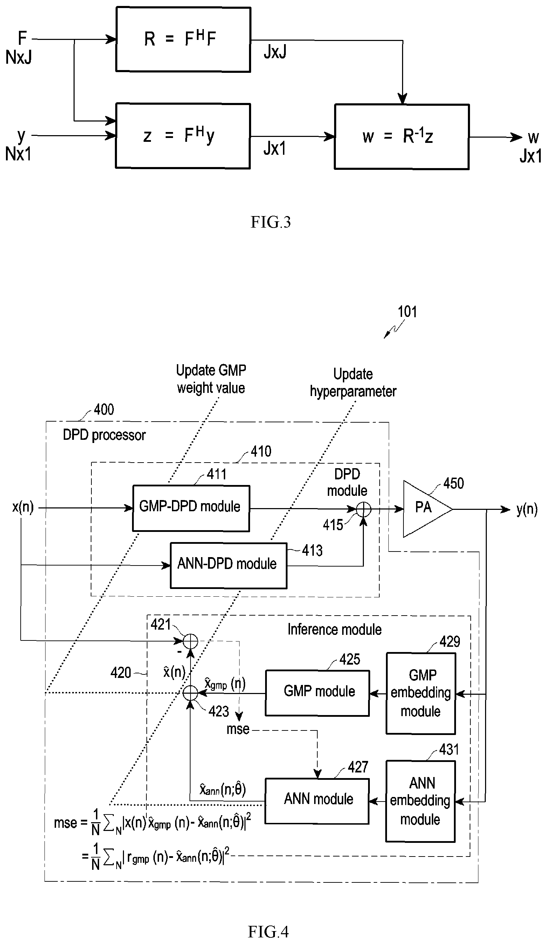

In an embodiment, the wireless communication module 192 may include an inference module included in a digital pre-distortion (DPD) processor. The DPD processor may include a DPD module and an inference module. In an embodiment, the inference module may identify (or may generate, or may obtain, or may calculate, or may determine) a weight for a first DPD scheme based on a generalized memory polynomial (GMP) scheme (e.g., a GMP-DPD scheme). The DPD processor including the inference module, according to an embodiment, is further described with reference to FIG. 4, so a redundant description thereof may be omitted herein.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

In an embodiment, the antenna module 197 may include the DPD module included in the DPD processor. The DPD processor may include the DPD module and the inference module. In an embodiment, the DPD module may perform a DPD operation based on the weight (e.g., a weight for the GMP-DPD scheme) identified by the inference module. The DPD processor including the DPD module, according to an embodiment, is further described with reference to FIG. 4, so a redundant description thereof may be omitted herein.

In an embodiment, the DPD processor may be implemented in a form including the DPD module and the inference module, however, the DPD module and the inference module may be implemented as one module. The inference module included in the DPD processor may be included in the wireless communication module 192, and the DPD module included in the DPD processor may be included in the antenna module 197. However, the present disclosure is not limited in this regard, and there may be no limitation on locations where the inference module and the DPD module may be deployed.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

Although FIG. 1 depicts, as an example, a case where the DPD processor, including the DPD module and the inference module, is implemented in the electronic device 101, the DPD processor may be implemented in a base station.

Since the number of antennas included in the electronic device 101 may be relatively small when compared to the number of antennas included in a base station, an implementation complexity of a DPD processor implemented in the electronic device 101 may be lower than an implementation complexity of a DPD processor implemented in the base station. The lower implementation complexity may stem from the DPD operation being applied to all antennas, and the electronic device 101 typically having a smaller amount of antennas. For example, if the base station uses an ultra-massive MIMO scheme, the number of antenna elements (and/or antennas) may be relatively large (e.g., one thousand (1,000) or more), and as a result, the implementation complexity when the DPD processor is implemented in the base station may be higher than the implementation complexity when the DPD processor is implemented in the electronic device 101.

The implementation complexity when the DPD processor, according to an embodiment, is implemented in the base station may increase when compared to the implementation complexity when the DPD processor, according to an embodiment, is implemented in the electronic device 101. However, the increase complexity may be caused by the larger number of antennas included in the base station compared to the number of antennas included in the electronic device 101, and there may be no significant increase in implementation complexity due to other aspects. In addition, the DPD processor based on the DPD scheme, according to an embodiment, may have a reduced implementation complexity when compared to a DPD processor that uses a related DPD scheme regardless of whether the related DPD processor is implemented in an electronic device and/or a base station, as further described below, so a redundant description thereof may be omitted herein.

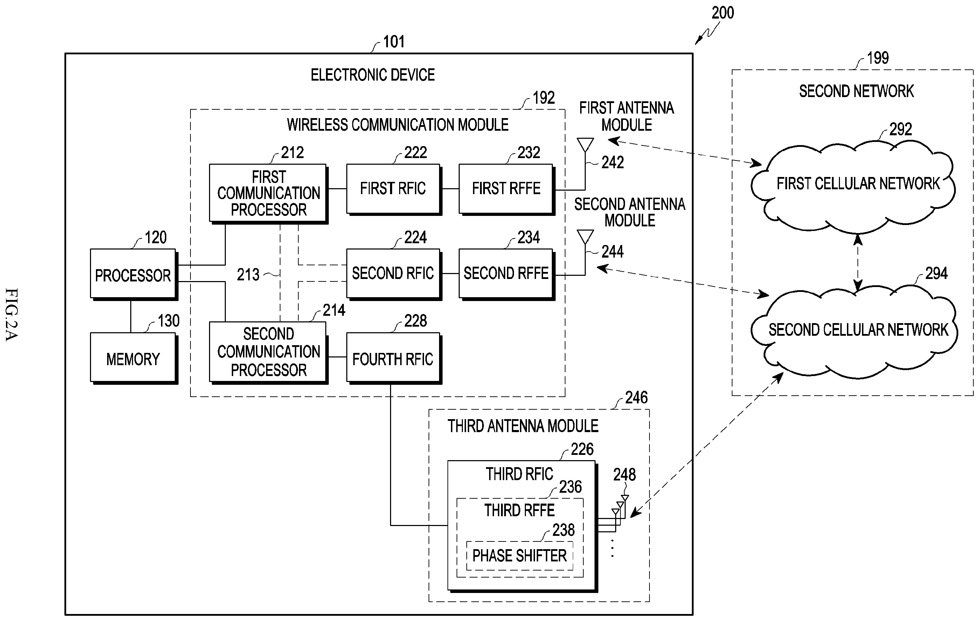

FIG. 2A is a block diagram illustrating an electronic device for supporting a legacy network communication and a 5^{th} generation (5G) network communication, according to an embodiment.

Referring to FIG. 2A, a block diagram 200 depicts an electronic device 101 (e.g., the electronic device 101 in FIG. 1) that may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, a third antenna module 244, and a plurality of antennas 248. The electronic device 101 may further include a processor 120 and memory 130. A second network 199 may include a first cellular network 292 and a second cellular network 294.According to an embodiment, the electronic device 101 may further include at least one of the components illustrated in FIG. 1, and the second network 199 may further include at least one other network. According to an embodiment, the first communication processor 212, the second communication processor 214, the first RFIC 222, the second RFIC 224, the fourth RFIC 228, the first RFFE 232, and the second RFFE 234 may form at least part of a wireless communication module 192. According to an embodiment, the fourth RFIC 228 may be omitted and/or included as part of the third RFIC 226.

The first communication processor 212 may establish a communication channel in a band to be used for a wireless communication with the first cellular network 292 and may support a legacy network communication via the established communication channel. According to an embodiment, the first cellular network 292 may be and/or may include a legacy network such as, but not limited to, a 2^{nd} generation (2G) network, a 3^{rd} generation (3G) network, a 4^{th} generation (4G) network, a long term evolution (LTE) network, or the like.

The second communication processor 214 may establish a communication channel corresponding to a specified band (e.g., about 6 gigahertz (GHz) to about 60 GHz) out of a band to be used for a wireless communication with the second cellular network 294 and may support a 5G network communication via the established communication channel. According to an embodiment, the second cellular network 294 may be and/or may include, but not be limited to, a 5G network defined by the 3rd generation partnership project (3GPP). Alternatively or additionally, according to an embodiment, the first communication processor 212 and/or the second communication processor 214 may establish a communication channel corresponding to another specified band (e.g., about 6 GHz or less) out of the band to be used for the wireless communication with the second cellular network 294 and may support a 5G network communication via the established communication channel.

The first communication processor 212 may transmit and/or receive data to and/or from the second communication processor 214. For example, data intended to be transmitted via the second cellular network 294 may be scheduled to be transmitted via the first cellular network 292. In such a case, the first communication processor 212 may receive transmission data from the second communication processor 214. For example, the first communication processor 212 may transmit and/or receive data to and/or from the second communication processor 214 via an inter-processor interface 213. The inter-processor interface 213 may be implemented as, for example, a universal asynchronous receiver/transmitter (UART) (e.g., high speed-UART (HS-UART)), a peripheral component interconnect bus express (PCIe) interface, or the like. However, the present disclosure is not limited in this regard, and a type of the inter-processor interface may vary without departing from the scope of the present disclosure.

Alternatively or additionally, the first communication processor 212 and the second communication processor 214 may exchange control information and/or packet data information by using, for example, a shared memory. The first communication processor 212 may transmit and/or receive various pieces of information such as, but not limited to, sensing information, information about output strength, and/or resource block (RB) allocation information to and/or from the second communication processor 214.

According to an embodiment, the first communication processor 212 may not be coupled directly to the second communication processor 214. For example, the first communication processor 212 may transmit and/or receive data to and/or from the second communication processor 214 via the processor 120 (e.g., an application processor). As another example, the first communication processor 212 and the second communication processor 214 may transmit and/or receive data to and/or from the processor 120 via an HS-UART interface and/or a PCIe interface. However, a type of the interface is not limited by the present disclosure. Alternatively or additionally, the first communication processor 212 and the second communication processor 214 may exchange control information and/or packet data information by using, for example, the processor 120 and the shared memory.

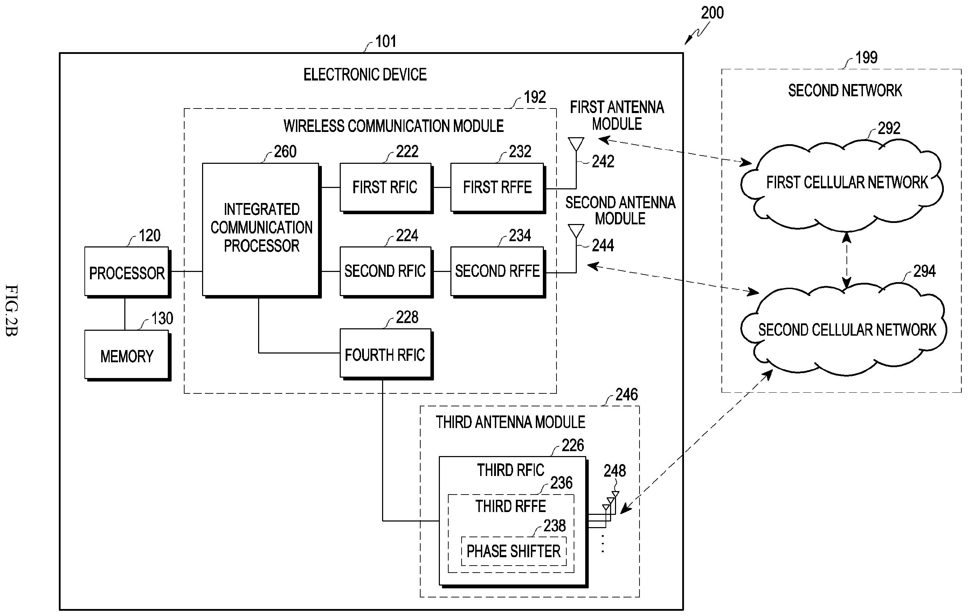

According to an embodiment, the first communication processor 212 and the second communication processor 214 may be incorporated in a single chip or a single package. According to an embodiment, the first communication processor 212 and/or the second communication processor 214 may be incorporated together with the processor 120, an auxiliary processor 123, or a communication module 190 in a single chip or a single package. For example, as illustrated in FIG. 2B, an integrated communication processor 260 may support and/or perform all communication functions that may be performed with the first cellular network 292 and the second cellular network 294.

For transmission, the first RFIC 222 may convert a baseband signal generated by the first communication processor 212 to a radio frequency (RF) signal (e.g., from about 700 megahertz (MHz) to about 3 GHz) used in the first cellular network 292 (e.g., the legacy network). For reception, an RF signal may be obtained from the first cellular network 292 via an antenna (e.g., the first antenna module 242) and pre-processed via an RFFE (e.g., the first RFFE 232). The first RFIC 222 may convert the pre-processed RF signal to a baseband signal so that the baseband signal may be processed by the first communication processor 212.

For transmission, the second RFIC 224 may convert a baseband signal generated by the first communication processor 212 and/or the second communication processor 214 to an RF signal in a Sub6 band (e.g., about 6 GHz or less) used in the second cellular network 294 (e.g., the 5G network). For reception, a 5G Sub6 RF signal may be obtained from the second cellular network 294 via an antenna (e.g., the second antenna module 244) and pre-processed in an RFFE (e.g., the second RFFE 234). The second RFIC 224 may convert the pre-processed 5G Sub6 RF signal to a baseband signal so that the baseband signal may be processed by a corresponding one between the first communication processor 212 and the second communication processor 214.

For transmission, the third RFIC 226 may convert a baseband signal generated by the second communication processor 214 to an RF signal (hereinafter, referred to as, a 5G Above6 RF signal) in a 5G Above6 band (e.g., about 6 GHz to about 60 GHz) used in the second cellular network 294. For reception, a 5G Above6 RF signal may be obtained from the second cellular network 294 via an antenna (e.g., an antenna of the plurality of antennas 248) and pre-processed via the third RFFE 236. The third RFIC 226 may convert the pre-processed 5G Above6 RF signal to a baseband signal so that the baseband signal may be processed by the second communication processor 214. According to an embodiment, the third RFFE 236 may be formed as part of the third RFIC 226.

According to an embodiment, the electronic device 101 may include the fourth RFIC 228 separately from and/or as part of the third RFIC 226. The fourth RFIC 228 may convert a baseband signal generated by the second communication processor 214 to an RF signal in an intermediate frequency band (e.g., about 9 GHz to about 11 GHz) (hereinafter, referred to as an intermediate frequency (IF) signal), and provide the IF signal to the third RFIC 226. The third RFIC 226 may convert the IF signal to a 5G Above6 RF signal. During reception, a 5G Above6 RF signal may be received from the second cellular network 294 through an antenna (e.g., an antenna of the plurality of antennas 248) and converted to an IF signal by the third RFIC 226. The fourth RFIC 228 may convert the IF signal to a baseband signal so that the baseband signal may be processed by the second communication processor 214.

According to an embodiment, the first RFIC 222 and the second RFIC 224 may be implemented as at least part of a single chip or a single package. According to an embodiment, if the first RFIC 222 and the second RFIC 224 are implemented as a single chip or a single package in FIG. 2A or 2B, the first RFIC 222 and the second RFIC 224 may be implemented as an integrated RFIC. In this case, the integrated RFIC is connected to the first RFFE 232 and the second RFFE 234, so the integrated RFIC may convert a baseband signal into a signal of a band supported by the first RFFE 232 and/or the second RFFE 234, and transfer the converted signal to one of the first RFFE 232 and the second RFFE 234. According to an embodiment, the first RFFE 232 and the second RFFE 234 may be implemented as at least part of a single chip or a single package. According to an embodiment, at least one of the first antenna module 242 or the second antenna module 244 may be omitted and/or combined with the other antenna module to process RF signals in a plurality of corresponding bands.

According to an embodiment, the third RFIC 226 and at least one antenna of the plurality of antennas 248 may be arranged on the same substrate to form a third antenna module 246. For example, the wireless communication module 192 and/or the processor 120 may be arranged on a first substrate (e.g., a main PCB). In this case, the third RFIC 226 may be arranged in a partial area (e.g., the bottom surface) of a second substrate (e.g., a sub PCB) other than the first substrate and the at least one antenna of the plurality of antennas 248 may be arranged in another partial area (e.g., the top surface) of the second substrate, to form the third antenna module 246. As the third RFIC 226 and the at least one antenna of the plurality of antennas 248 are arranged on the same substrate, it may be possible to reduce a length of a transmission line between the third RFIC 226 and the at least one antenna of the plurality of antennas 248. As a result, for example, a loss (e.g., attenuation) of a signal in a high frequency band (e.g., about 6 GHz to about 60 GHz) used for a 5G network communication, on the transmission line, may be reduced. Consequently, the electronic device 101 may provide an increased quality and/or a speed of a communication with the second cellular network 294 (e.g., the 5G network), when compared to a related electronic device.

According to an embodiment, the plurality of antennas 248 may be formed as an antenna array including a plurality of antenna elements that may be used for beamforming. For example, the third RFIC 226 may include a plurality of phase shifters 238 corresponding to the plurality of antenna elements, as part of the third RFFE 236. During transmission, each of the plurality of phase shifters 238 may change a phase of a 5G Above6 RF signal to be transmitted to the outside of the electronic device 101 (e.g., a base station in the 5G network) via a corresponding antenna element. During reception, each of the phase shifters 238 may change a phase of a 5G Above6 RF signal received from the outside via a corresponding antenna element to a substantially similar and/or the same phase. In such a manner, transmission and/or reception via beamforming between the electronic device 101 and the outside may be performed.

The second cellular network 294 may be operated independently of the first cellular network 292 (e.g., stand-alone (SA)) or in connection to the first cellular network 292 (e.g., non-stand alone (NSA)). For example, in the 5G network, only an access network (e.g., a 5G radio access network (RAN) or next generation RAN (NG RAN)) may exist, and a core network (e.g., a next generation core (NGC)) may not exist. In such an example, after accessing the access network of the 5G network, the electronic device 101 may access an external network (e.g., an Internet) under the control of a core network (e.g., an evolved packet core (EPC)) of the legacy network. Protocol information for a communication with the legacy network (e.g., LTE protocol information) and protocol information for a communication with the 5G network (e.g., new radio (NR) protocol information) may be stored in the memory 130 and accessed by another component (e.g., the processor 120, the first communication processor 212, or the second communication processor 214).

The internal structure of the electronic device 101 for supporting the legacy network communication and the 5G network communication has been described with respect to RFICs and RFEEs as an example, as shown in FIG. 2A. However, the number of RFICs and/or RFFEs included in a base station may be different from the number of RFICs and RFFEs included in the electronic device 101. In general, the number of RFICs included in the base station may be equal to or larger than the number of RFFEs included in the base station. For example, the number of the RFFEs may be N, where N may be a positive integer greater than or equal to four (4) (e.g., N ≥ 4). A digital front-end (or RFFE) may perform beamforming to increase the number of data transmission paths to be equal to the number of the RFICs. In an embodiment, the beamforming may include digital beamforming and/or analog beamforming.

Continuing to refer to FIG. 2A, an operation of converting an input signal into a signal corresponding to a set frequency band of each of the first RFIC 222, the second RFIC 224, the third RFIC 226, and the fourth RFIC 228 has been described as an example, for ease of description. However, in practice, an RFIC may not be limited to having a one-to-one correspondence with an antenna. For example, the number of the RFICs and the number of antennas connected to the RFICs may be different.

Additionally, as described with reference to FIG. 2A, an RFIC may have a one-to-one correspondence with a set frequency band in the electronic device 101. However, the present disclosure is not limited in this regard. For example, an RFIC may not have a one-to-one correspondence with a set frequency band in the base station, as described below.

In an embodiment, a base station may include a plurality of RFICs and a plurality of RFEEs. In the base station, an RFIC may support a plurality of frequency bands. For example, the RFIC included in the base station may be and/or may include a wideband element that may integrate and/or support a plurality of frequency bands rather than one (1) frequency band. Accordingly, in the base station, an RFIC supported per each antenna path may vary. For example, if the number of antenna paths that may be supported by the RFIC (e.g., a wideband RFIC) is M and the number of antennas required in an RFFE corresponding to the RFIC is N, $\frac{N}{M}$ RFICs may be needed, where N and M are positive integers greater than zero (0).

FIG. 2B is a block diagram illustrating an electronic device for supporting a legacy network communication and a 5G network communication, according to an embodiment.

Referring to FIG. 2B, a block diagram 250 of the electronic device 101 may include and/or may be similar in many respects to the block diagram 200 described above with reference to FIG. 2A, and may include additional features not mentioned above. Furthermore, the electronic device 101 of FIG. 2B may include and/or may be similar in many respects to electronic device 101 described above with reference to FIGS. 1 and 2A, and may include additional features not mentioned above. Consequently, repeated descriptions of the block diagram 250 and the electronic device 101 described above with reference to FIGS. 1 and 2A may be omitted for the sake of brevity.

Referring to FIGS. 2A and 2B together, the electronic device 101 shown in FIG. 2B may differ from the electronic device 101 shown in FIG. 2A, in that the first communication processor 212 and the second communication processor 214 are implemented as the integrated communication processor 260.

According to an embodiment, the wireless communication module 192 may include an inference module included in a DPD processor. The DPD processor may include a DPD module and the inference module. In an embodiment, the inference module may identify (or may generate, or may obtain, or may calculate, or may determine) a weight for a first digital pre-distortion (DPD) scheme based on a generalized memory polynomial (GMP) scheme (e.g., a GMP-DPD scheme). The DPD processor including the inference module, according to an embodiment, is further described with reference to FIG. 4, so a repeated description thereof may be omitted herein.

In an embodiment, the antenna modules in FIGS. 2A and 2B (e.g., the first antenna module 242, the second antenna module 244, and the third antenna module 246) may include the DPD module included in the DPD processor. The DPD processor may include the DPD module and the inference module. In an embodiment, the DPD module may perform a DPD operation based on a weight value (e.g., a weight value for a GMP-DPD scheme) identified by the inference module. The DPD processor including the DPD module, according to an embodiment, may be further described with reference to FIG. 4, so a repeated description thereof may be omitted herein.

In an embodiment, the DPD processor may be implemented in a form of including the DPD module and the inference module, but the DPD module and the inference module may be implemented as one module. The inference module included in the DPD processor is included in the wireless communication module 192, and the DPD module included in the DPD processor may be included in the antenna modules (e.g., the first antenna module 242, the second antenna module 244, and the third antenna module 246). However, the present disclosure is not limited in this regard, and there may be no limitation on locations where the inference module and the DPD module may be deployed.

An embodiment of the disclosure may provide an electronic device for supporting digital pre-distortion (DPD) and an operating method thereof.

An embodiment of the disclosure may provide an electronic device for performing a DPD operation based on a generalized memory polynomial (GMP) scheme and an artificial-intelligence neural network (ANN) and an operating method thereof.

In an embodiment, the GMP scheme may be a representative example of a Volterra scheme. In an embodiment, non-linear distortion may include non-linear distortion based on the GMP scheme and non-linear residual distortion not based on the GMP scheme. For example, the non-linear residual distortion that is not based on the GMP scheme may be based on a non-linear characteristic for a Gallium nitride (GaN) trapped signal. Hereinafter, for convenience of a description, the non-linear distortion based on the GMP scheme may be referred to as GMP distortion, and the non-linear residual distortion not based on the GMP scheme may be referred to as non-linear residual distortion.

Among DPD schemes that may not be based on an ANN, a representative scheme may include a GMP LS DPD scheme, which is a DPD scheme based on a least squared (LS) solution that is based on the GMP scheme. The GMP LS DPD scheme is described by D. R. Morgan, et al., "A Generalized Memory Polynomial Model for Digital Predistortion of RF Power Amplifiers", in IEEE Trans. on Signal Processing, Vol. 54, No. 10, pp. 3852-3860 (Oct. 2006), the disclosure of which is incorporated by reference herein in its entirety. The GMP LS DPD scheme may be described as follows.

In the GMP LS DPD scheme, an output signal of a power amplifier (PA) (e.g., a high power amplifier (HPA)) at a time domain sample n may be represented as y_{GMP}(n), and the output signal y_{GMP}(n) of the PA may be expressed by a memory polynomial similar to Equation 1. For example, the output signal y_{GMP}(n) of the PA may be expressed in a form of a multiplier product of an input signal x(n) of the PA and a magnitude of the input signal x(n), as expressed in Equation 1 below, and the multiplier product of the input signal x(n) and the magnitude of the input signal x(n) may be delayed (or lagging) and/or advanced (or leading) to affect the output signal y_{GMP}(n) of the PA.
<Equation1> [Equation 1] $\begin{matrix}{y}_{GMP} \left(n\right) = {{{\sum }_{l = 0}^{{L}_{a} - 1} {\sum }_{k = 0}^{{K}_{a} - 1} {a}_{l , k} \left(n-l\right) {\left|x\left(n-l\right)\right|}^{k}}_{︸}}_{{L}_{a} {K}_{a} coefficients for aligned signal and envelope} \\ + {{{\sum }_{l = 0}^{{L}_{b} - 1} {\sum }_{k = 1}^{{K}_{b}} {\sum }_{m = 1}^{{M}_{b}} {b}_{l , k , m} x \left(n-l\right) {\left|x\left(n-l-m\right)\right|}^{k}}_{︸}}_{{L}_{b} {K}_{b} {M}_{b} coefficients for signal and delayed envelope} \\ + {{{\sum }_{l = 0}^{{L}_{c} - 1} {\sum }_{k = 1}^{{K}_{c}} {\sum }_{m = 1}^{{M}_{c}} {c}_{l , k , m} x \left(n-l\right) {\left|x\left(n-l+m\right)\right|}^{k}}_{︸}}_{{L}_{c} {K}_{c} {M}_{c} coefficients for signal and advanced envelope}\end{matrix}$

Referring to Equation 1, n may represent a time domain sample index, *l* may represent a delay tap index, ${\sum }_{l = 0}^{{L}_{a} - 1} {\sum }_{k = 0}^{{K}_{a} - 1} {a}_{l , k} x \left(n-l\right) {\left|x\left(n-l\right)\right|}^{k}$ may represent *LₐKₐ* coefficients for a signal that is time-aligned with the input signal of the PA and an envelope (or a memory polynomial), ${\sum }_{l = 0}^{{L}_{b} - 1} {\sum }_{k = 1}^{{K}_{b}} {\sum }_{m = 1}^{{M}_{b}} {b}_{l , k , m} x \left(n-l\right) {\left|x\left(n-l-m\right)\right|}^{k}$ may represent *L_{b}K_{b}M_{b}* coefficients for an envelope that is time-delayed from the input signal of the PA, and ${\sum }_{l = 0}^{{L}_{c} - 1} {\sum }_{k = 1}^{{K}_{c}} {\sum }_{m = 1}^{{M}_{c}} {c}_{l , k , m} x \left(n-l\right) {\left|x\left(n-l+m\right)\right|}^{k}$ may represent *L_{c}K_{c}M_{c}* coefficients for an envelope that is time-advanced compared to the input signal of the PA.

Continuing to refer to Equation 1, a parameter *Lₐ* may represent a magnitude of memory depth for a product of the input signal of the PA and the signal that is time-aligned with the input signal of the PA, and a parameter *Kₐ* may represent a multiplier of a magnitude of a signal for the product of the input signal of the PA and the signal that is time-aligned with the input signal of the PA.

When defining a column vector ***w*** including a coefficient *a_{l,k},* a coefficient *b_{l,k,m},* and a coefficient *c_{l,k,m},* and a feature row vector ***F***(*n*) including a feature of a product of a signal and a magnitude of the signal, such as *x*(*n* - *l*)|*x*(*n* - *l* - *m*)|*^{k},* Equation 1 may be expressed in a form of a product of the feature row vector ***F***(*n*) and the column vector w, as an equation similar to Equation 2. <Equation 2> ${y}_{GMP} \left(n\right) = F \left(n\right) w$

Referring to Equation 2, if J is assumed to be a sum of *LₐKₐ, L_{b}K_{b}M_{b},* and *L_{c}K_{c}M_{c}* (e.g., J *= LₐKₐ + L_{b}K_{b}M_{b} + L_{c}K_{c}M_{c}*), the column vector ***w*** with a size of J × 1 may be expressed as an equation similar to Equation 3. <Equation 3> $w = {\left[{{⋯ {a}_{l , k} ⋯}_{︸}}_{{L}_{a} {K}_{a}} {{⋯ {b}_{l , k , m} ⋯}_{︸}}_{{L}_{b} {K}_{b} {M}_{b}} {{⋯ {c}_{l , k , m} ⋯}_{︸}}_{{L}_{c} {K}_{c} {M}_{c}}\right]}^{T}$

Referring to Equation 3, [·]*^{T}* may represent a transpose function.

In addition, the feature row vector ***F***(*n*) with a size of 1 × J may be expressed as an equation similar to Equation 4. <Equation 4> $F \left(n\right) = \left[\begin{matrix}{{⋯ x \left(n-l\right) {\left|x\left(n-l\right)\right|}^{k} ⋯}_{︸}}_{{L}_{a} {K}_{a}} \\ {{⋯ x \left(n-l\right) {\left|x\left(n-l-m\right)\right|}^{k} ⋯}_{︸}}_{{L}_{b} {K}_{b} {M}_{b}} {{⋯ x \left(n-l\right) {\left|x\left(n-l-m\right)\right|}^{k} ⋯}_{︸}}_{{L}_{c} {K}_{c} {M}_{c}}\end{matrix}\right]$

Since Equation 2 represents the output signal of the PA when considering a specific time domain sample, for example, a time domain sample with a time domain sample index n, when considering a set period (e.g., when considering a plurality of samples (e.g., N time domain samples)), the output signal of the PA may be expressed in a form of a matrix-vector product as an equation similar to Equation 5. <Equation 5> $y = Fw$

Referring to Equation 5, a dimension of each matrix and each vector may be as follows.

A dimension of a column vector ***y**,* which may represent the output signal of the PA, may be N × 1, a dimension of a feature matrix ***F**,* which includes a plurality of feature column vectors corresponding to the PA, may be N × J, and a dimension of the column vector ***w***, which includes coefficients of a feature vector, may be J × 1.

In Equation 5, the column vector ***w*** may generally be obtained (or may be verified or may be calculated) as an LS solution, and if an estimated J × 1-dimensional LS solution is defined as ***ŵ***, the estimated J × 1-dimensional LS solution ***ŵ*** may be expressed as an equation similar to Equation 6. <Equation 6> $\hat{w} = {\left({F}^{H}F\right)}^{- 1} {F}^{H} y$

Referring to Equation 6, the column vector ***y*** may represent observed data (or observed signal or observation vector) for obtaining the LS solution.

FIG. 3 is a diagram for describing an operation of obtaining an LS solution in a GMP-DPD scheme, according to an embodiment.

Referring to FIG. 3, a GMP-DPD scheme (e.g., a GMP LS DPD scheme) may refer to a DPD scheme based on a GMP scheme. For example, the GMP-DPD scheme may be a scheme of obtaining an LS solution as described with reference to Equation 6 and applying the obtained LS solution to a DPD operation.

As illustrated in FIG. 3, if a matrix ***R*** and a matrix ***z*** are defined as ***F**^{H}**F*** and ***F**^{H} **y**,* respectively (e.g., ***R** = **F**^{H}**F, z** = **F**^{H}**y***), a column vector ***w*** may be expressed as ***R*⁻¹*z*** (e.g., ***w*** = ***R*⁻¹*z***). A dimension (or a size) of a matrix ***F*** may be N × J, a dimension of a column vector ***y*** may be N × 1, a dimension of the feature matrix ***F*** may be N × J, a dimension of a column vector ***w*** may be J × 1, a dimension of the matrix ***R*** may be J × J, and/or a dimension of the matrix ***z*** may be J × 1.

That is, the GMP-DPD scheme may be a scheme in which accuracy for the DPD scheme may be guaranteed as the number of time samples (e.g., the number of accumulated time samples) N as shown in Equation 5 increases and as accuracy of the GMP scheme increases (e.g., as a size of J increases). In the GMP-DPD scheme, an amount of multiplication and addition computations according to a magnitude of each of N may be expressed as in Tables 1 and 2 below.

Referring to Tables 1 and 2 below, it may be assumed that an inverse matrix operation used for obtaining the LS may apply an algorithm that may perform forward-backward substitution after Cholesky decomposition.

**[Table 1]**

| **Operation** | | **Real Multiplier** | **Real Adder** |
|---|---|---|---|
| Auto Correlation | | 2NJ² | (2N - 1)J² |
| Cross Correlation | | 4NJ | 2(2N - 1)J |
| Matrix Inversion | Cholesky Decomposition | 2J(J² - 1)/3 | J(J - 1)(2J - 1)/3 |
| | Forward Substitution | 2J² | 2J(J - 1) |
| | Backward Substitution | 2J² | 2J(J - 1) |

**[Table 2]**

| **N** | **J** | **Real Multiplier** | **Real Adder** |
|---|---|---|---|
| 4,096 | 256 | 552,512,000 | 552,379,648 |
| 4,096 | 512 | 2,246,398,976 | 2,245,872,128 |
| 8,192 | 256 | 1,093,577,216 | 1,093,444,864 |
| 8,192 | 512 | 4,402,271,232 | 4,401,744,384 |

As shown in Tables 1 and 2, a computational amount of the inverse matrix computation used for obtaining the LS in the GMP-DPD scheme is O(J3), thus, it may be understood that as an accuracy of the GMP scheme increases (e.g., as J increases), a corresponding computational amount may increase exponentially. Further, it may be understood that as a period of ensemble average increases (e.g., as a magnitude of N increases in order to secure statistical reliability of the GMP scheme), a computational amount needed for auto-correlation and cross-correlation may increase proportionally.

The ANN-DPD scheme may be based on an ANN inference model to which training has been applied in advance, and may update parameters of the ANN with output data of the ANN-DPD scheme. The ANN-DPD scheme may perform a computation based on output data and/or observation data (or observation signal or observation vector), and may perform DPD operation in a form of reflecting a non-linear characteristic of the PA (e.g., the HPA) based on a non-linear characteristic of the ANN. However, the ANN-DPD scheme may need a relatively long time for training the ANN, as well as, it may be difficult to identify an optimal time point for hyperparameters of the ANN.

In an embodiment of the disclosure, a DPD scheme may reflect a non-linear characteristic of a PA, similar to an ANN-DPD scheme, while using an LS solution, similar to a GMP-DPD scheme. Hereinafter, for convenience of description, a DPD scheme, according to an embodiment of the disclosure, may be referred to as a generalized memory polynomial-artificial-intelligence neural network (GMP-ANN) DPD scheme.

According to an embodiment, in the GMP-ANN DPD scheme, if an input signal (e.g., a target signal, target data, a target data vector, or the like) of a PA (e.g., an HPA) used in the GMP-DPD scheme and an ANN-DPD scheme is represented as *x*(*n*)*,* optimization of the GMP-ANN DPD scheme may be implemented as a scheme of training parameters in a form of decreasing (e.g., minimizing) a mean squared error (MSE) between the input signal *x(n)* of the PA and an input signal *x̂*(*n*) that may be estimated in an indirect manner. In an embodiment, the MSE between the input signal *x(n)* of the PA and the estimated input signal *x̂*(*n*) may be expressed as an equation similar to Equation 7. <Equation 7> $mse \frac{1}{N} \sum {\left|x\left(n\right)-\hat{x}n\right|}^{2}$

Referring to Equation 7, *mse* may represent the MSE between the input signal *x(n)* of the PA and the estimated input signal *x̂*(*n*)*,* and *N* may represent the number of time domain samples.

The estimated input signal *x̂*(*n*) may be a sum (e.g., *x̂*(*n*) = *x̂_{gmp}*(*n*) *+ x̂ₐₙₙ*(*n*)) of an input signal *x̂_{gmp}*(*n*) that may be estimated based on the GMP-DPD scheme and an input signal *x̂ₐₙₙ*(*n*) that may be estimated based on the ANN-DPD scheme.

When considering *x̂*(*n*) = *x̂_{gmp}*(*n*) + *x̂ₐₙₙ*(*n*)*,* Equation 7 may be expressed as an equation similar to Equation 8. <Equation 8> $\begin{matrix}mse = \frac{1}{N} \sum {\left|x\left(n\right)-{\hat{x}}_{gmp}\left(n\right)-{\hat{x}}_{ann}\left(n\right)\right|}^{2} \\ = \frac{1}{N} \sum {\left|{r}_{gmp}\left(n\right)-{\hat{x}}_{ann}\left(n\right)\right|}^{2}\end{matrix}$

Referring to Equation 8, *r_{gmp}*(*n*) may represent a residual between the input signal *x(n)* of PA at a time domain sample *n* and the input signal *x̂_{gmp}*(*n*) estimated via the GMP-DPD scheme, and *r_{gmp}*(*n*) may be expressed as *r_{gmp}*(*n*) = *x̂*(*n*) - *x̂_{gmp}*(*n*).

In an embodiment, if a cost function *Jₐₙₙ*(*θ*) of an ANN for which a hyperparameter *θ* is represented as ${J}_{ann} \left(θ\right) = \frac{1}{N} {\sum }_{N} {\left|{r}_{gmp}\left(n\right)-{\hat{x}}_{ann}\left(n; θ\right)\right|}^{2}$, the hyperparameter *θ* of the ANN may be trained by a scheme that may decrease (minimize) the residual *r_{gmp}*(*n*) between the input signal *x(n)* of the PA and the input signal *x̂_{gmp}*(*n*) estimated via the GMP-DPD scheme. The trained hyperparameter *θ̂* may be expressed as an equation similar to Equation 9. <Equation 9> $\hat{θ} = arg {min}_{θ} {J}_{ann} \left(θ\right) = arg {min}_{θ} \frac{1}{N} {\sum }_{N} {\left|{r}_{gmp}\left(n\right)-{\hat{x}}_{ann}\left(n; θ\right)\right|}^{2}$

For example, if *LₐKₐ* coefficients for a signal that is time-aligned with the input signal among signals included in *y_{gmp}*(*n*) in Equation 1 and an envelope are represented as ${y}_{GMP}^{1 D} \left(n\right)$ (e.g., if the *LₐKₐ* coefficients are represented as ${y}_{GMP}^{1 D} \left(n\right) ≜ {\sum }_{l = 0}^{{L}_{a} - 1} {\sum }_{k = 0}^{{K}_{a} - 1} {a}_{l , k} x \left(n-l\right) \left.{\left|x\left(n-l\right)\right|}^{k}\right)$ , *y_{gmp}*(*n*) may be expressed as an equation similar to Equation 10 below. <Equation 10> ${y}_{GMP} \left(n\right) = {y}_{GMP}^{1 D} \left(n\right) + {r}_{gmp} \left(n\right)$

Referring to Equation 10, *J*_{1*D*} may be equal to *LₐKₐ,* and since *LₐKₐ* is relatively smaller than J (e.g., *J*₁*_{D} = LₐKₐ* « J), the output signal *y_{GMP}*(*n*) of the PA may be expressed by a relatively simple memory polynomial as Equation 10. Thus, the GMP-ANN DPD scheme, according to an embodiment of the disclosure, may obtain an LS solution based on a relatively simple memory polynomial as Equation 10. Although FIG. 3 depicts a case where the output signal *y_{GMP}*(*n*) of the PA is implemented by a relatively simple memory polynomial, for example, using ${y}_{GMP}^{1 D} \left(n\right)$*,* the present disclosure is not limited in this regard. For example, various schemes to simplify the memory polynomial corresponding to the output signal *y_{GMP}*(*n*) of the PA may be used without departing from the scope of the present disclosure. That is, there may be no limitation on a scheme to simplify the memory polynomial corresponding to the output signal *y_{GMP}*(*n*) of the PA.

By training and updating the ANN in a form of decreasing (minimizing) r*_{gmp}*(n) that may represent the residual between the output signal *y_{GMP}*(*n*) of the PA and an actual output signal of the PA in the GMP-ANN DPD scheme as described in Equation 10, the DPD scheme may be applied by considering a non-linear characteristic of high-order polynomial components of the PA.

FIG. 4 is a block diagram schematically illustrating a DPD processor 400, according to an embodiment.

Referring to FIG. 4, an electronic device 101 (e.g., an electronic device 101 in FIGS. 1, 2A, and/or 2B) may include a DPD processor 400 and/or a PA 450. For example, the PA 450 may be included in an RFFE circuit (e.g., a first RFFE circuit 232, a second RFFE circuit 234, and/or a third RFFE circuit 236 in FIGS. 2A and/or 2B) included in the electronic device 101.

In an embodiment, the DPD processor 400 may perform a DPD operation (e.g., a GMP-ANN DPD operation). The DPD processor 400 may be included in the electronic device 101 (e.g., the electronic device 101 in FIGS. 1, 2A, and/or 2B) and/or a base station. For example, if the DPD processor 400 is included in the electronic device 101, the DPD processor 400 may be implemented as a MODEM, and/or a processor (e.g., a processor 120 in FIGS. 1, 2A, and/or 2B), a communication processor (e.g., a first communication processor 212 and/or a second communication processor 214 in FIG. 2A), and/or an integrated communication processor (e.g., an integrated processor 260 in FIG. 2B). However, the present disclosure is not limited in this regard, and there may be no limitation on a form in which the DPD processor 400 may be implemented and/or a location where the DPD processor 400 may be deployed .

In an embodiment, the DPD processor 400 may include a DPD module 410 and an inference module 420. In an embodiment, the DPD module 410 may include a GMP-DPD module 411, an ANN-DPD module 413, and/or an adder 415. In an embodiment, the inference module 420 may include a first adder 421, a second adder 423, a GMP module 425, an ANN module 427, a GMP embedding module 429, and/or an ANN embedding module 431. Although FIG. 4 depicts a case in which the DPD processor 400 is implemented in the form of including a plurality of modules, such as the DPD module 410 including the GMP-DPD module 411, the ANN-DPD module 413, and/or the adder 415, and the inference module 420 including the first adder 421, the second adder 423, the GMP module 425, the ANN module 427, the GMP embedding module 429, and/or the ANN embedding module 431, the present disclosure is not limited in this regard, and there may be no limitation on a form in which the DPD processor 400 may be implemented.

In an embodiment, the DPD module 410 may be included in an antenna module 197 of the electronic device 101 in FIG. 1, and the inference module 420 may be included in a wireless communication module 192 of the electronic device 101 in FIG. 1. In an embodiment, the DPD processor 400 may be implemented in a form of including the DPD module 410 and the inference module 420, but the DPD module 410 and the inference module 420 may be implemented as one module.

Although FIG. 4 depicts a case in which the inference module 420 included in the DPD processor 400 is included in the wireless communication module 192, and the DPD module 410 included in the DPD processor 400 is included in the antenna module 197, the present disclosure is not limited in this regard, and there may be no limitation on locations where the inference module 420 and the DPD module 410 may be deployed.

In an embodiment, the GMP module 425 may identify (or obtain or determine) a GMP weight value ***ŵ****_{GMP}* for the GMP-DPD scheme. In an embodiment, the GMP weight value ***ŵ****_{GMP}* may represent a weight value for a first DPD (GMP-DPD) scheme based on a GMP scheme. In order to identify the GMP weight value ***ŵ****_{GMP},* a data embedding operation for GMP data may need to be performed, and the data embedding operation may be performed by the GMP embedding module 429.

In an embodiment, the GMP embedding module 429 may perform a data embedding operation on an input signal. The input signal of the GMP embedding module 429 may be an output signal y(n) of the PA 450. The GMP embedding module 429 may configure a modified memory polynomial, such as an equation similar to Equation 11, by changing a function related to an envelope or a magnitude of a signal described in a memory polynomial of the GMP-DPD scheme as expressed in Equation 1. <Equation 11> $\begin{matrix}{\hat{x}}_{GMP} \left(n\right) = {\sum }_{l = 0}^{{L}_{a} - 1} {\sum }_{k = 0}^{{K}_{a} - 1} {\hat{a}}_{l , k} y \left(n-l\right) {H}_{k} \left(\left|y\left(n-l\right)\right|\right) \\ + {\sum }_{l = 0}^{{L}_{b} - 1} {\sum }_{k = 1}^{{K}_{b}} {\sum }_{m = 1}^{{M}_{b}} {\hat{b}}_{l , k , m} y \left(n-l\right) {H}_{k} \left(\left|y\left(n-l-m\right)\right|\right) \\ + {\sum }_{l = 0}^{{L}_{c} - 1} {\sum }_{k = 1}^{{K}_{c}} {\sum }_{m = 1}^{{M}_{c}} {\hat{c}}_{l , k , m} y \left(n-l\right) {H}_{k} \left(\left|y\left(n-l+m\right)\right|\right)\end{matrix}$

Referring to Equation 11, *Hₖ*(|*y*(*n*)|) may represent a basic envelope function for an observation signal *y(n).* For example, the GMP embedding module 429 may perform a data embedding operation for an input signal by configuring *Hₖ*(|*y*(*n*)|), which may be the basic envelope function for the observation signal *y*(*n*), as a power series type or a Legendre polynomial type based on a characteristic of the PA 450.

For example, if the basic envelope function *H_{y}*(|*y*(*n*)|) is configured as the power series type, *Hₖ*(|*y*(*n*)|) may be expressed as an equation similar to Equation 12. <Equation 12> ${H}_{k} \left(\left|y\left(n\right)\right|\right) = {\left|y\left(n\right)\right|}^{k}$

The basic envelope function expressed in Equation 12 may represent a power series type-basic envelope function.

For example, if the basic envelope function *H_{y}*(|*y*(*n*)|) is configured as the Legendre polynomial type, *Hₖ*(|*y*(*n*)|) may be expressed as an equation similar to Equation 13. <Equation 13> $\begin{matrix}{H}_{0} \left(\left|y\left(n\right)\right|\right) = 1 \\ {H}_{1} \left(\left|y\left(n\right)\right|\right) = 0.5 \left(12{\left(\frac{\left|y\left(n\right)\right|}{α}-\frac{1}{2}\right)}^{2}-1\right) \\ {H}_{2} \left(\left|y\left(n\right)\right|\right) = 0.5 \left(40{\left(\frac{\left|y\left(n\right)\right|}{α}-\frac{1}{2}\right)}^{3}-6\left(\frac{\left|y\left(n\right)\right|}{α}-\frac{1}{2}\right)\right) \\ {H}_{3} \left(\left|y\left(n\right)\right|\right) = 0.125 \left(560{\left(\frac{\left|y\left(n\right)\right|}{α}-\frac{1}{2}\right)}^{4}-120{\left(\frac{\left|y\left(n\right)\right|}{α}-\frac{1}{2}\right)}^{2}+3\right) \\ {H}_{4} \left(\left|y\left(n\right)\right|\right) = 012.5 \left(\begin{matrix}2016 {\left(\frac{\left|y\left(n\right)\right|}{α}-\frac{1}{2}\right)}^{5} - 560 {\left(\frac{\left|y\left(n\right)\right|}{α}-\frac{1}{2}\right)}^{3} \\ + 30 \left(\frac{\left|y\left(n\right)\right|}{α}-\frac{1}{2}\right)\end{matrix}\right)\end{matrix}$

Referring to Equation 13, *α* may be an arbitrary constant.

The basic envelope function expressed in Equation 13 may be a Legendre type-basic envelope function.

As described above, if the basic envelope function *Hₖ*(|*y*(*n*)|) is configured as the power series type, Equation 11 may have the same form as the memory polynomial of the GMP-DPD scheme as Equation 1. Therefore, the GMP embedding module 429 may implement the same form as the memory polynomial of the GMP-DPD scheme (e.g., the memory polynomial in Equation 1) in a relatively simple manner, and thus may reduce computational amount required to detect an LS solution in the GMP-DPD scheme, thereby also potentially reducing implementation complexity.

In an embodiment, the ANN module 427 may train parameters of the ANN based on the residual. In order to train the parameters of the ANN, a data embedding operation for the observation signal *y*(*n*) suitable for training the ANN may be performed. The data embedding operation may be performed by the ANN embedding module 431.

In an embodiment, the ANN embedding module 431 may perform the data embedding operation on the input signal. The input signal of the ANN embedding module 431 may be the output signal y(n) of the PA 450.

For example, the ANN embedding module 431 may perform a data embedding operation based on a basic data type on the observation signal *y(n).* The data embedding operation based on the basic data type may be expressed as an equation similar to Equation 14. <Equation 14> ${\left[Re\left\{y\left(n\right)\right\} Im\left\{y\left(n\right)\right\} Re\left\{y\left(n-1\right)\right\} Im\left\{y\left(n-1\right)\right\} … Re\left\{y\left(n-L-2\right)\right\} Im\left\{y\left(n-L-2\right)\right\} Re\left\{y\left(n-L-1\right)\right\} Im\left\{y\left(n-L-1\right)\right\}\right]}^{T}$

Referring to Equation 14, *L* may represent a magnitude of an observation signal used for training the ANN, *Re{y(n)}* may represent a real value of a complex *y(n),* and *Im{y(n)}* may represent an imaginary value of the complex *y(n).*

For example, the ANN embedding module 431 may perform the data embedding operation based on the basic envelope function on the observation signal *y*(*n*)*.* The basic envelope function may include a power series type-basic envelope function as described with reference to Equation 12 and/or a Legendre type-basic envelope function as described with reference to Equation 13.

For example, the ANN embedding module 431 may perform the data embedding operation based on the power series type basic envelope function on the observation signal *y*(*n*)*.* The data embedding operation based on the power series type-basic envelope function may be expressed as an equation similar to Equation 15. <Equation 15> $\left[\begin{matrix}Re \left\{y\left(n\right)\right\} Im \left\{y\left(n\right)\right\} \left|y\left(n\right)\right| ⋯ {\left|y\left(n\right)\right|}^{K} ⋯ \\ Re \left\{y\left(n-L-1\right)\right\} Im \left\{y\left(n-L-1\right)\right\} \\ \left|y\left(n-L-1\right)\right| ⋯ {\left|y\left(n-L-1\right)\right|}^{K}\end{matrix}\right]$

Referring to Equation 15, *K* may represent a maximum multiplier of the power series type-basic envelope function used for training the ANN.

For example, the ANN embedding module 431 may perform the data embedding operation based on the Legendre type-basic envelope function on the observation signal y(n). The data embedding operation based on the Legendre type-basic envelope function may be expressed as an equation similar to Equation 16. <Equation 16> $\left[\begin{matrix}Re \left\{y\left(n\right)\right\} Im \left\{y\left(n\right)\right\} {H}_{1} \left(\left|y\left(n\right)\right|\right) ⋯ \\ Re \left\{y\left(n-L-1\right)\right\} Im \left\{y\left(n-L-1\right)\right\} \\ {H}_{1} \left(\left|y\left(n-L-1\right)\right|\right) ⋯ {H}_{K} \left(\left|y\left(n-L-1\right)\right|\right)\end{matrix}\right]$

Referring to Equation 16, *K* may represent a maximum degree of the Legendre type-basic envelope function used for training the ANN. In Equation 16, *K* may be set to a value less than or equal to four (4) (e.g., *K* ≤ 4).

In an embodiment, the GMP module 425 may input *x̂_{CMP}*(*n*) as expressed in Equation 11 transferred from the GMP embedding module 429 and identify (or obtain or determine) the GMP weight value ***ŵ****_{GMP}* for the GMP-DPD scheme based on *x̂_{GMP}*(*n*)*.* The GMP module 425 that may identify the weight value *x̂_{GMP}*(*n*) may transfer the GMP weight value ***ŵ****_{GMP}* to the GMP-DPD module 411. The GMP-DPD module 411 may perform the GMP-DPD operation based on the GMP weight value ***ŵ****_{GMP}* transferred from the GMP module 425. In an embodiment, non-linear distortion may include non-linear distortion (or GMP distortion) based on the GMP scheme and non-linear residual distortion not based on the GMP scheme. For example, the non-linear residual distortion not based on the GMP scheme may be based on a non-linear characteristic of a GaN trapped signal. In an embodiment, the GMP-DPD module 411 may correct non-linear distortion (or non-linear data) included in the input signal of the PA 450 based on the GMP weight value ***ŵ****_{GMP}* transferred from the GMP module 425. In an embodiment, the non-linear distortion corrected by the GMP-DPD module 411 may be the GMP distortion.

The GMP module 425 that may identify the GMP weight value ***ŵ****_{GMP}* may transfer, to the second adder 423, the input signal *x̂_{gmp}*(*n*) of the PA 450 estimated via the GMP-DPD scheme based on the GMP weight value *_{ŵ}_{GMP}.*

In an embodiment, the ANN module 427 may input a result of the data embedding operation performed on the observation signal y(n), which may be transferred from the ANN embedding module 431, and train the parameters of the ANN based on the result of the data embedding operation performed on the input observation signal *y(n).* The ANN module 427 that trains the parameters of the ANN may identify (or obtain or determine) the input signal *x̂ₐₙₙ*(*n*; *θ*) estimated based on the ANN-DPD scheme that considers a hyperparameter *θ* of the ANN.

In an embodiment, the second adder 423 may add the input signal *x̂_{gmp}*(*n*) of the PA estimated via the GMP-DPD scheme transferred from the GMP module 425 and the input signal *x̂ₐₙₙ*(*n*; *θ*) estimated based on the ANN-DPD scheme transmitted from the ANN module 427 to generate the input signal *x̂*(*n*) estimated based on the GMP-ANN DPD scheme, and transfer the generated input signal *x̂*(*n*) to the first adder 421.

The first adder 421 may generate an MSE by subtracting the estimated input signal *x̂*(*n*) of the PA 450 transferred from the second adder 423 from the input signal *x(n)* of the PA 450. In an embodiment, the MSE may be expressed as $mse = \frac{1}{N} {\sum }_{N} {\left|x\left(n\right)-\hat{x}\left(n\right)\right|}^{2}$ as described with reference to Equation 7. In an embodiment, if the estimated input signal *x̂*(*n*) is a sum (e.g., *x̂*(*n*) = *x̂_{gmp}*(*n*) *+ x̂ₐₙₙ*(*n*)) of the input signal *x̂_{gmp}*(*n*) estimated based on the GMP-DPD scheme and the input signal *x̂ₐₙₙ*(*n*) estimated based on the ANN-DPD scheme, the MSE may be expressed as an equation similar to Equation 17. <Equation 17> $\begin{matrix}mse = \frac{1}{N} {\sum }_{N} {\left|x\left(n\right)-{\hat{x}}_{gmp}\left(n\right)-{\hat{x}}_{ann}\left(n; \hat{θ}\right)\right|}^{2} \\ = \frac{1}{N} {\sum }_{N} {\left|{r}_{gmp}\left(n\right)-{\hat{x}}_{ann}\left(n; θ\right)\right|}^{2}\end{matrix}$

The first adder 421 may transfer the generated MSE to the ANN module 427, thereby the ANN module 427 may train the hyperparameter *θ* of the ANN in a scheme that may decrease(e.g., minimize) the MSE between the input signal *x(n)* of the PA 450 and the estimated input signal *x̂*(*n*) of the PA 450. The scheme of minimizing the MSE between the input signal *x(n)* of the PA 450 and the estimated input signal *x̂*(*n*) of the PA 450 may be implemented in a scheme that may be substantially similar and/or the same as the scheme described with reference to Equations 7 to 9. In this case, the ANN module 427 may train the hyperparameter *θ* of the ANN in a scheme that may decrease (e.g., minimize) a residual *r_{gmp}* (n) between the input signal *x̂*(*n*) of the PA 450 and the input signal *x̂_{gmp}*(*n*) estimated via the GMP-DPD scheme. In an embodiment, the ANN module 427 may update the hyperparameter *θ* by training the hyperparameter *θ* of the ANN in the scheme that may minimize the residual *r_{gmp}*(*n*) between the input signal *x(n)* of the PA 450 and the input signal *x̂_{gmp}*(*n*) estimated via the GMP-DPD scheme. The ANN module 427 may transfer the updated hyperparameter *θ̂* to the ANN-DPD module 413.

The ANN-DPD module 413 may perform an ANN-DPD operation based on the updated hyperparameter *θ̂* transferred from the ANN module 427. In an embodiment, the ANN-DPD module 413 may correct the non-linear distortion (or the non-linear data) included in the input signal of the PA 450 based on the updated hyperparameter *θ̂* transferred from the ANN module 427. In an embodiment, the non-linear distortion corrected in the ANN-DPD module 413 may be non-linear residual distortion. In an embodiment, the non-linear distortion corrected in the ANN-DPD module 413 may be different from the non-linear distortion corrected in the GMP-DPD module 411 in an embodiment.

According to an embodiment of the disclosure, an electronic device 101 may comprise a power amplifier (PA) 450, and at least one processor (e.g., at least one of processors 120, 212, 214, or 260) connected to the PA.

According to an embodiment of the disclosure, the at least one processor may be configured to identify (or monitor), during a set period, input data of the PA and output data of the PA.

According to an embodiment of the disclosure, the at least one processor may be configured to, based on the input data of the PA and the output data of the PA, identify a weight value for a first digital pre-distortion (DPD) scheme that is based on a generalized memory polynomial (GMP) scheme.

According to an embodiment of the disclosure, the at least one processor may be configured to, based on estimated input data of the PA estimated based on a second DPD scheme that is based on a neural network (NN) scheme and estimated input data of the PA estimated based on the first DPD scheme, and the input data of the PA, identify a hyperparameter for the second DPD scheme.

According to an embodiment of the disclosure, the at least one processor may be configured to, based on the weight value, correct first non-linear data included in the input data of the PA based on the first DPD scheme.

According to an embodiment of the disclosure, the at least one processor may be configured to, based on the hyperparameter, correct second non-linear data included in the input data of the PA based on the second DPD scheme.

According to an embodiment of the disclosure, the at least one processor may be configured to, as at least part of, identifying the hyperparameter for the second DPD scheme based on the estimated input data of the PA estimated based on the second DPD scheme and the estimated input data of the PA estimated based on the first DPD scheme, and the input data of the PA, identify the hyperparameter that decreases a difference between the estimated input data of the PA estimated based on the second DPD scheme and the estimated input data of the PA estimated based on the first DPD scheme and the input data of the PA.

According to an embodiment of the disclosure, the at least one processor may be configured to, as at least part of, identifying the hyperparameter for the second DPD scheme based on the estimated input data of the PA estimated based on the second DPD scheme and the estimated input data of the PA estimated based on the first DPD scheme, and the input data of the PA, identify the hyperparameter that decreases a mean squared error (MSE) between the estimated input data of the PA estimated based on the second DPD scheme and the estimated input data of the PA estimated based on the first DPD scheme, and the input data of the PA.

According to an embodiment of the disclosure, the at least one processor may be configured to, as at least part of, identifying the hyperparameter for the second DPD scheme based on the estimated input data of the PA estimated based on the second DPD scheme and the estimated input data of the PA estimated based on the first DPD scheme, and the input data of the PA, identify the hyperparameter that decreases a residual between the input data of the PA and the estimated input data of the PA estimated based on the first DPD scheme.

According to an embodiment of the disclosure, the at least one processor may be configured to perform data embedding on the output data of the PA to identify the estimated input data of the PA estimated based on the first DPD scheme.

According to an embodiment of the disclosure, the data embedding may be based on a basic envelope function.

According to an embodiment of the disclosure, the basic envelope function may include at least one of a power series type basic envelope function or a Legendre type basic envelope function, based on a characteristic of the PA.

According to an embodiment of the disclosure, the at least one processor may be configured to perform data embedding on the output data of the PA to identify the estimated input data of the PA estimated based on the second DPD scheme.

According to an embodiment of the disclosure, the data embedding may be based on a basic envelope function.

According to an embodiment of the disclosure, the basic envelope function may include at least one of a power series type basic envelope function or a Legendre type basic envelope function, based on a characteristic of the PA.

According to an embodiment of the disclosure, the data embedding may be based on a magnitude of the output data of the PA, and a real value and an imaginary value of the output data of the PA.

According to an embodiment of the disclosure, the GMP scheme may be based on coefficients for data that is time-aligned with the input data of the PA and an envelope in a set time domain sample, and a residual between the input data of the PA and the estimated input data of the PA estimated based on the first DPD scheme in the set time domain sample.

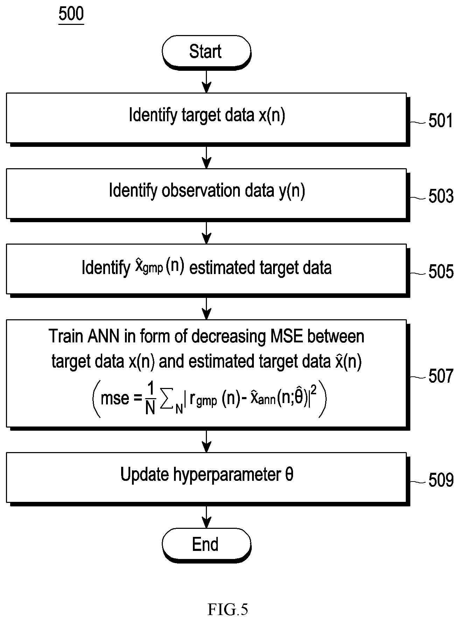

FIG. 5 is a flow diagram 500 schematically illustrating an operating process of a DPD processor 400 according to an embodiment.

Prior to a description of FIG. 5, a DPD processor 400 may be a processor that may perform a DPD operation, and the DPD processor 400 may be included in an electronic device 101 (e.g., the electronic device 101 of FIGS. 1, 2A, 2B, and/or 4) and/or a base station. For example, if the DPD processor 400 is included in the electronic device, the DPD processor 400 may be implemented as a MODEM, and/or a processor (e.g., the processor 120 of FIGS. 1, 2A, and/or 2B), a communication processor (e.g., the first communication processor 212 and/or the second communication processor 214 of FIG. 2A), and/or an integrated communication processor (e.g., the integrated processor 260 in FIG. 2B). However, the present disclosure is not limited in this regard, and there may be no limitation on a form in which the DPD processor 400 may be implemented and/or a location where the DPD processor 400 may be deployed. As described with reference to FIG. 4, the DPD processor 400 may include a DPD module 410 and an inference module 420, the DPD module 410 may include a GMP-DPD module 411 and/or an ANN-DPD module 413, and the inference module 420 may include a GMP module 425 and/or an ANN module 427.

Referring to FIG. 5, the DPD processor 400 (e.g., the ANN module 427) may identify (e.g., capture, obtain, or determine) target data (or a target signal) *x(n)* in operation 501. In an embodiment, the target data may represent an input signal *x(n)* of a PA (e.g., an HPA) (e.g., the PA 450 of FIG. 4) related to a GMP-ANN DPD operation. For example, the DPD processor 400 may identify target data for a set number (e.g., N) of time domain samples.

The DPD processor 400 that identifies the target data *x(n)* may identify (e.g., capture, obtain, or determine) observation data (or an observation signal) *y*(*n*) in operation 503. In an embodiment, the observation data *y(n)* may represent an output signal *y(n)* of the PA (e.g., the HPA) (e.g., the PA 450 of FIG. 4) related to the GMP-ANN DPD operation. For example, the DPD processor 400 may identify the observation data for the set number (e.g., N) of time domain samples.

The DPD processor 400 that identifies the observation data y(n) may identify (e.g., calculate, obtain, or determine) target data *x̂_{gmp}*(*n*) estimated based on a GMP-DPD scheme in operation 505. In an embodiment, the DPD processor 400 may identify the estimated target data *x̂_{gmp}*(*n*) based on a relatively simple memory polynomial such as, but not limited to, ${y}_{GMP} \left(n\right) = {y}_{GMP}^{1 D} \left(n\right) + {r}_{gmp} \left(n\right)$, as described with reference to Equation 10.

The DPD processor 400 that identifies the target data *x̂_{gmp}*(*n*) estimated based on the GMP-DPD scheme may train an ANN in a form of decreasing (e.g., minimizing) an MSE between the target data *x(n)* and target data *x̂*(*n*) estimated based on a GMP-ANN DPD scheme in operation 507.

In an embodiment, the MSE between the target data *x(n)* and the target data *x̂*(*n*) estimated based on the GMP-ANN DPD scheme may be expressed as *mse =* $\frac{1}{N} {\sum }_{N} {\left|x\left(n\right)-\hat{x}\left(n\right)\right|}^{2}$, as described with reference to Equation 7.

The estimated target data *x̂*(*n*) may be a sum (e.g., *x̂*(*n*) = *x̂_{gmp}*(*n*) *+ x̂ₐₙₙ*(*n*)) of the target data *x̂_{gmp}*(*n*) estimated based on the GMP-DPD scheme and the input signal *x̂ₐₙₙ*(*n*) estimated based on the ANN-DPD scheme, and in this case, the MSE may be expressed as described with reference to Equation 8.

Considering the hyperparameter *θ* of the ANN-DPD scheme, the MSE as described in Equation 8 may be expressed as described with reference to Equation 17.

Thus, the DPD processor 400 may train the ANN in a form of decreasing (e.g., minimizing) the MSE as described with reference to Equation 17, in operation 507.

The DPD processor 400 that trains the ANN in the form of minimizing the MSE may update the hyperparameter *θ* of the ANN-DPD scheme in operation 509. In an embodiment, the DPD processor 400 may update the hyperparameter *θ* of the ANN-DPD scheme when identifying an update request for the hyperparameter *θ*. In an embodiment, the update request for the hyperparameter *θ* may be identified based on an event in which the hyperparameter *θ* may need to be updated. The event in which the hyperparameter *θ* may need to be updated may occur due to various causes (e.g., a set period). That is the present disclosure is not limited in this regard, and there may be no limitation on the event in which the hyperparameter *θ* may need to be updated.

Although FIG. 5 depicts a case in which the DPD processor 400 updates the hyperparameter *θ* based on the target data and the observation data for the set number (e.g., N) of time domain samples, as described with reference to operations 501 to 509, the present disclosure is not limited in this regard. For example, operations such as operations 501 to 509 may be repeated a set number of times (e.g., M times) to ultimately update the hyperparameter θ.

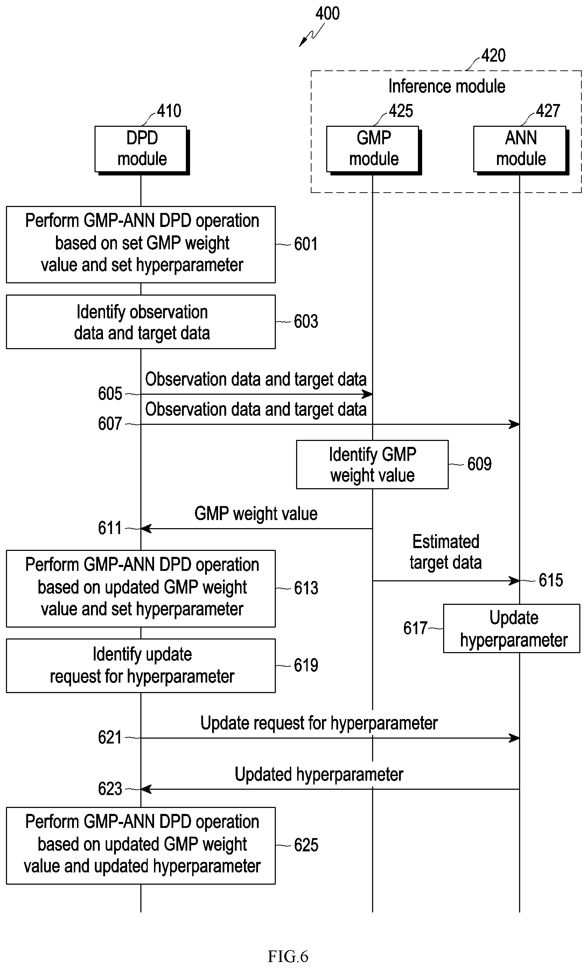

FIG. 6 is a signal flow diagram schematically illustrating an operating process of a DPD processor 400, according to an embodiment.

Prior to a description of FIG. 6, a DPD processor 400 may be a processor that may perform a DPD operation, and the DPD processor 400 may be included in an electronic device 101 (e.g., the electronic device 101 of FIGS. 1, 2A, 2B, and/or 4) and/or a base station. For example, if the DPD processor 400 is included in the electronic device, the DPD processor 400 may be implemented as a MODEM, and/or a processor (e.g., the processor 120 of FIGS. 1, 2A, and/or 2B), a communication processor (e.g., the first communication processor 212 and/or the second communication processor 214 in FIG. 2A), and/or an integrated communication processor (e.g., the integrated processor 260 in FIG. 2B). However, the present disclosure is not limited in this regard, and there may be no limitation on a form in which the DPD processor 400 may be implemented and/or a location where the DPD processor 400 may be deployed. As described with reference to FIG. 4, the DPD processor 400 may include a DPD module 410 and an inference module 420, the DPD module 410 may include a GMP-DPD module 411 and/or an ANN-DPD module 413, and the inference module 420 may include a GMP module 425 and/or an ANN module 427.

Referring to FIG. 6, in operation 601, the DPD module 410 may perform a GMP-ANN DPD operation based on a set GMP weight value ***ŵ****_{GMP}* and/or a set hyperparameter *θ*. In an embodiment, a GMP weight value ***ŵ****_{GMP}* may represent a solution (e.g., an LS solution) of a GMP-DPD scheme. In an embodiment, a hyperparameter *θ* may represent a hyperparameter of an ANN-DPD scheme, a cost function of the ANN may be represented as *Jₐₙₙ*(*θ*), and ${J}_{ann} \left(θ\right) = \frac{1}{N} {\sum }_{N} {\left|{r}_{gmp}\left(n\right)-{\hat{x}}_{ann}\left(n; θ\right)\right|}^{2}$. In an embodiment, the set GMP weight value ***ŵ****_{GMP}* may be a default set-GMP weight value ***ŵ****_{GMP}* or a GMP weight value ***ŵ****_{GMP}* set (or updated) before operation 601. In an embodiment, the set hyperparameter *θ* may be a default set hyperparameter *θ* or a hyperparameter *θ* set (or updated) before operation 601.

While performing the GMP-ANN DPD operation based on the set GMP weight value ***ŵ****_{GMP}* and/or the set hyperparameter *θ*, the DPD module 410 may update the GMP weight value ***ŵ****_{GMP}* of the GMP-DPD scheme and/or the hyperparameter *θ* of the ANN-DPD scheme. According to an embodiment, after updating the GMP weight value ***ŵ****_{GMP}* of the GMP-DPD scheme, the hyperparameter *θ* of the ANN-DPD scheme may be updated, or after updating the hyperparameter *θ* of the ANN-DPD scheme, the GMP weight value ***_{ŵ}****_{GMP}* of the GMP-DPD scheme may be updated, or the GMP weight value ***ŵ****_{GMP}* of the GMP-DPD scheme and the hyperparameter *θ* of the ANN-DPD scheme may be updated simultaneously. In FIG. 6, it may be assumed that the GMP weight value ***ŵ****_{GMP}* of the GMP-DPD scheme is updated and then the hyperparameter *θ* of the ANN-DPD scheme is updated.

In FIG. 6, since it is assumed that the hyperparameter *θ* of the ANN-DPD scheme is updated after the GMP weight value ***ŵ****_{GMP}* of the GMP-DPD scheme is updated, the DPD module 410 may identify (e.g., capture, obtain, or determine) observation data (or an observation signal or an observation data vector) and target data (or a target signal or a target data vector) in operation 603. In an embodiment, the observation data may represent an output signal *y*(*n*) of a PA (e.g., an HPA) (e.g., the PA 450 in FIG. 4) related to the GMP-ANN DPD operation, and the target data may represent an input signal *x*(*n*) of the PA related to the GMP-ANN DPD operation. For example, the DPD module 410 may identify the observation data and the target data for a set number (e.g., N) of time domain samples.

The DPD module 410 that identifies the observation data and target data may transfer the identified observation data and target data to the GMP module 425 in operation 605, and may transfer the identified observation data and target data to the ANN module 427 in operation 607.

The GMP module 425 that receives the observation data and the target data from the DPD module 410 may identify (e.g., calculate, obtain, or determine) the GMP weight value ***ŵ****_{GMP}* of the GMP-DPD scheme in operation 609.

The GMP module 425 that identifies the GMP weight value ***ŵ****_{GMP}* of the GMP-DPD scheme may transfer the GMP weight value ***ŵ****_{GMP}* to the DPD module 410 in operation 611.

The DPD module 410 that receives the GMP weight value ***ŵ****_{GMP}* from the GMP module 425 may update the GMP weight value ***ŵ****_{GMP}* of the GMP-DPD scheme with the GMP weight value ***ŵ****_{GMP}* received from the GMP module 425 in operation 613. The DPD module 410 that updates the GMP weight value ***ŵ****_{GMP}* of the GMP-DPD scheme may perform the GMP-ANN DPD operation based on the updated GMP weight value ***ŵ****_{GMP}* and/or the set hyperparameter *θ* (e.g., the set hyperparameter *θ* in operation 601) in operation 613. Operations 603 to 613 may be a process for updating the GMP weight value ***ŵ****_{GMP},* and the process for updating the GMP weight value ***ŵ****_{GMP}* may be performed whenever observation data and target data for the set number of time domain samples are identified. The DPD module 410 may repeatedly perform the process of updating the GMP weight value ***ŵ****_{GMP}* as described in operations 603 to 613 until the update request for the hyperparameter *θ* of the ANN-DPD scheme is identified.

The GMP module 425 that identifies the GMP weight value ***ŵ****_{GMP}* of the GMP-DPD scheme in operation 609 may estimate target data based on the identified GMP weight value ***ŵ****_{GMP}* and transfer the estimated target data *x̂*(*n*) to the ANN module 427 in operation 615.

The ANN module 427 that receives the estimated target data *x̂*(*n*) from the GMP module 425 may update the hyperparameter *θ* of the ANN-DPD scheme in operation 617. In an embodiment, the ANN module 427 may update the hyperparameter *θ* via background processing even if a request for the hyperparameter *θ* for updating the hyperparameter *θ* is not received from the DPD module 410. In an embodiment, the ANN module 427 may update the hyperparameter *θ* whenever the ANN module 427 receives the estimated target data *x̂*(*n*) from the GMP module 425. The ANN module 427 may update the hyperparameter *θ* in a substantially similar and/or the same scheme as described with reference to FIG. 5. Consequently, repeated descriptions thereof may be omitted for the sake of brevity.

The DPD module 410 that repeatedly performs the process of updating the GMP weight value ***ŵ****_{GMP}* as described in operations 603 to 613 may identify the update request for the hyperparameter *θ* of the ANN-DPD scheme in operation 619. In an embodiment, the update request for the hyperparameter *θ* may be identified based on an event in which the hyperparameter *θ* may need to be updated. The event in which the hyperparameter *θ* may need to be updated may occur due to various causes (e.g., a set period). That is, the present disclosure is not limited in this regard, and there may be no limitation on the event in which the hyperparameter *θ* may need to be updated.

The DPD module 410 that identifies the update request for the hyperparameter *θ* may transfer the update request for the hyperparameter *θ* to the ANN module 427 in operation 621.

The ANN module 427 that receives the update request for the hyperparameter *θ* from the DPD module 410 may transmit the updated hyperparameter *θ̂* to the DPD module 410 in operation 623. The ANN module 427 may transfer the updated hyperparameter *θ̂* to the DPD module 410 via the background processing in operation 623.

The DPD module 410 that receives the updated hyperparameter *θ̂* from the ANN module 427 may perform the GMP-ANN DPD operation based on the updated GMP weight value ***ŵ****_{GMP}* and/or the updated hyperparameter *θ̂* in operation 625.

As described in FIG. 6, in an embodiment of the disclosure, instead of updating the GMP weight value *ŵ_{GMP}* and the hyperparameter *θ* simultaneously, the GMP weight value *ŵ_{GMP}* may be updated whenever the observation data and the target data for the set number of time domain samples are identified, and the hyperparameter *θ* may be updated based on the event in which the hyperparameter *θ* may need to be updated. The reason for separately updating the GMP weight value ***ŵ****_{GMP}* and the hyperparameter *θ* may be that the number of coefficients included in the GMP weight used in the GMP-DPD scheme is greater than the number of hyperparameters used in the ANN-DPD scheme. For example, the reason for separately updating GMP weight value ***ŵ****_{GMP}* and the hyperparameter *θ* may be that since the number of coefficients included in the GMP weight is greater than the number of hyperparameters, the hyperparameters may be updated at a relatively long period to reduce resources required for updating the hyperparameters, and the GMP weight value may be updated at a relatively short period to potentially improve a performance of the GMP-ANN DPD operation.

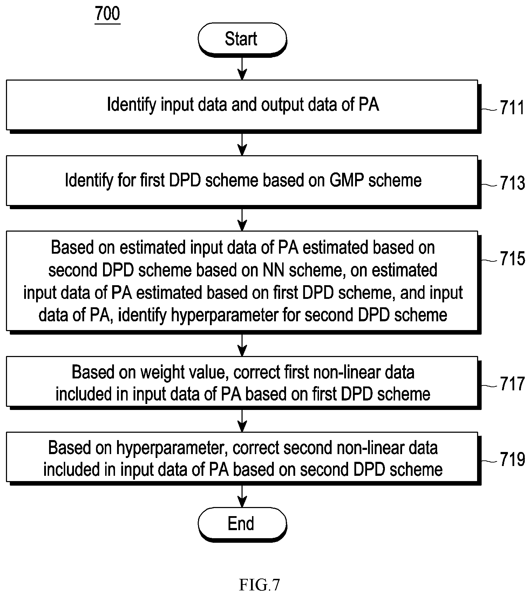

FIG. 7 is a flow diagram 700 schematically illustrating an operating process of a DPD processor, according to an embodiment.

Referring to FIG. 7, an electronic device (e.g., the electronic device 101 in FIGS. 1, 2A, and/or 2B) may include a processor (e.g., the processor 120 of FIGS. 1, 2A, or 2B, the first communication processor 212 the a second communication processor 214 of FIG. 2A, the integrated communication processor 260 of FIG. 2B, and/or the DPD processor 400 of FIG. 4) that may identify (e.g., capture, obtain, or determine) input data (or an input signal) of a PA (e.g., the PA 450 of FIG. 4) included in the electronic device 101 and output data (or an output signal) of the PA during a set period in operation 711. The input data of the PA may represent target data (or a target signal) of the PA.

The electronic device 101 that identifies the input data of the PA and the output data of the PA may, based on the input data of the PA and the output data of the PA, identify a weight value for a first DPD scheme based on a GMP scheme in operation 713. The GMP scheme may be based on coefficients for data that is time-aligned with the input data of the PA and an envelope in a set time domain sample, and a residual between the input data of the PA and estimated input data of the PA estimated based on the first DPD scheme in the set time domain sample. For example, the first DPD scheme based on the GMP scheme may be a GMP-DPD scheme, and the weight value for the first DPD scheme based on the GMP scheme may be a GMP weight value ***ŵ****_{GMP}* as described with reference to FIG. 4. Consequently, repeated descriptions thereof may be omitted for the sake of brevity.

The electronic device 101 that identifies the weight value for the first DPD scheme based on the GMP scheme may identify a hyperparameter *θ* for a second DPD scheme based on estimated input data of the PA estimated based on the second DPD scheme that is based on an NN scheme and estimated input data of the PA estimated based on the first DPD scheme, and the input data of the PA in operation 715. Operation 715 may be implemented in a substantially similar and/or the same manner as an operation of a DPD processor corresponding to Equation 17 as described with reference to FIG. 4. Consequently, repeated descriptions thereof may be omitted for the sake of brevity.

According to an embodiment, the electronic device may identify the hyperparameter that decreases a difference between the estimated input data of the PA estimated based on the second DPD scheme and the estimated input data of the PA estimated based on the first DPD scheme and the input data of the PA. According to an embodiment, the electronic device may identify the hyperparameter *θ* that decreases an MSE between the estimated input data of the PA estimated based on the second DPD scheme and the estimated input data of the PA estimated based on the first DPD scheme, and the input data of the PA. According to an embodiment, the electronic device may identify the hyperparameter *θ* that decreases a residual between the input data of the PA and the estimated input data of the PA estimated based on the first DPD scheme.

The electronic device 101 that identifies the hyperparameter *θ* for the second DPD scheme may correct, based on the weight value, first non-linear data included in the input data of the PA based on the first DPD scheme in operation 717. Operation 717 may be implemented in a substantially similar and/or the same manner as an operation in which a GMP-DPD module (e.g., the GMP-DPD module 411 of FIG. 4) may correct non-linear distortion (or non-linear data) included in the input signal of a PA (e.g., the PA 450 of FIG. 4) based on the GMP weight value ***ŵ****_{GMP}* transferred from a GMP module (e.g., the GMP module 425 of FIG. 4). Consequently, repeated descriptions thereof may be omitted for the sake of brevity.

The electronic device 101 that corrects the first non-linear data included in the input data of the PA based on the first DPD scheme may correct, based on the hyperparameter *θ*, second non-linear data included in the input data of the PA based on the second DPD scheme in operation 719. Operation 719 may be implemented in a substantially similar and/or the same manner as an operation in which an ANN-DPD module (e.g., the ANN-DPD module 413 of FIG. 4) may correct non-linear distortion (or non-linear data) included in the input signal of a PA (e.g., the PA 450 of FIG. 4) based on an updated hyperparameter transferred from an ANN module (e.g., the ANN module 427 of FIG. 4). Consequently, repeated descriptions thereof may be omitted for the sake of brevity.

According to an embodiment of the disclosure, a method of an electronic device 101 may include identifying, during a set period, input data of a power amplifier (PA) included in the electronic device 101 and output data of the PA.

According to an embodiment of the disclosure, the method may include, based on the input data of the PA and the output data of the PA, identifying a weight value for a first digital pre-distortion (DPD) scheme that is based on a generalized memory polynomial (GMP) scheme.

According to an embodiment of the disclosure, the method may include, based on estimated input data of the PA estimated based on a second DPD scheme that is based on a neural network (NN) scheme and estimated input data of the PA estimated based on the first DPD scheme, and the input data of the PA, identifying a hyperparameter for the second DPD scheme.

According to an embodiment of the disclosure, the method may include, based on the weight value, correcting first non-linear data included in the input data of the PA based on the first DPD scheme.

According to an embodiment of the disclosure, the method may include, based on the hyperparameter, correcting second non-linear data included in the input data of the PA based on the second DPD scheme.

According to an embodiment of the disclosure, identifying the hyperparameter for the second DPD scheme, based on the estimated input data of the PA estimated based on the second DPD scheme and the estimated input data of the PA estimated based on the first DPD scheme, and the input data of the PA, identifying the hyperparameter for the second DPD scheme may include identifying the hyperparameter that decreases a difference between the estimated input data of the PA estimated based on the second DPD scheme and the estimated input data of the PA estimated based on the first DPD scheme and the input data of the PA.

According to an embodiment of the disclosure, identifying the hyperparameter for the second DPD scheme based on the estimated input data of the PA estimated based on the second DPD scheme and the estimated input data of the PA estimated based on the first DPD scheme, and the input data of the PA may include identifying the hyperparameter that decreases a mean squared error (MSE) between the estimated input data of the PA estimated based on the second DPD scheme and the estimated input data of the PA estimated based on the first DPD scheme, and the input data of the PA.

According to an embodiment of the disclosure, identifying the hyperparameter for the second DPD scheme based on the estimated input data of the PA estimated based on the second DPD scheme and the estimated input data of the PA estimated based on the first DPD scheme, and the input data of the PA may include identifying the hyperparameter that decreases a residual between the input data of the PA and the estimated input data of the PA estimated based on the first DPD scheme.

According to an embodiment of the disclosure, the method may include performing data embedding on the output data of the PA to identify the estimated input data of the PA estimated based on the first DPD scheme.

According to an embodiment of the disclosure, the data embedding may be based on a basic envelope function.

According to an embodiment of the disclosure, the basic envelope function may include at least one of a power series type basic envelope function or a Legendre type basic envelope function, based on a characteristic of the PA.

According to an embodiment of the disclosure, the method may include performing data embedding on the output data of the PA to identify the estimated input data of the PA estimated based on the second DPD scheme.

According to an embodiment of the disclosure, the data embedding may be based on a basic envelope function.

According to an embodiment of the disclosure, the basic envelope function may include at least one of a power series type basic envelope function or a Legendre type basic envelope function, based on a characteristic of the PA.

According to an embodiment of the disclosure, the data embedding may be based on a magnitude of the output data of the PA, and a real value and an imaginary value of the output data of the PA.

According to an embodiment of the disclosure, the GMP scheme may be based on coefficients for data that is time-aligned with the input data of the PA and an envelope in a set time domain sample, and a residual between the input data of the PA and the estimated input data of the PA estimated based on the first DPD scheme in the set time domain sample.

The electronic device according to an embodiment may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that an embodiment of the disclosure and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1^{st}" and "2^{nd}," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with an embodiment of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or two or more functions. For example, according to an embodiment, the module may be implemented in a form of an application-specific integrated circuit (ASIC).

An embodiment as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a power amplifier (PA) (450);
one or more processors (120; 212; 214; 260) coupled with the PA; and
memory (130) storing instructions,
wherein the instructions, when executed by the one or more processors individually or collectively, cause the electronic device to:
monitor, during a set time period, input data of the PA and output data of the PA;
identify a weight value for a first digital pre-distortion (DPD) scheme which is based on a generalized memory polynomial (GMP) scheme, based on the input data of the PA and the output data of the PA;identify a hyperparameter for the second DPD scheme, based on estimated input data of the PA estimated based on a second DPD scheme which is based on a neural network (NN) scheme and estimated input data of the PA estimated based on the first DPD scheme, and the input data of the PA;
correct first non-linear data included in the input data of the PA based on the weight value and the first DPD scheme; and
correct second non-linear data included in the input data of the PA based on the hyperparameter and the second DPD scheme.

2. The electronic device of claim 1, wherein the instructions, when executed by the one or more processors individually or collectively, further cause the electronic device to:
identify the hyperparameter that decreases a difference between the estimated input data of the PA estimated based on the second DPD scheme and the estimated input data of the PA estimated based on the first DPD scheme and the input data of the PA.

3. The electronic device of claim 1, wherein the instructions, when executed by the one or more processors individually or collectively, further cause the electronic device to:
identify the hyperparameter that decreases a mean squared error (MSE) between the estimated input data of the PA estimated based on the second DPD scheme and the estimated input data of the PAestimated based on the first DPD scheme, and the input data of the PA.

4. The electronic device of claim 1, wherein the instructions, when executed by the one or more processors individually or collectively, further cause the electronic device to:
identify the hyperparameter that decreases a residual between the input data of the PA and the estimated input data of the PA estimated based on the first DPD scheme.

5. The electronic device of any one of claims 1 to 4, wherein the instructions, when executed by the one or more processors individually or collectively, further cause the electronic device to:
identify the estimated input data of the PA estimated based on the first DPD scheme by performing data embedding on the output data of the PA.

6. The electronic device of claim 5, wherein the instructions, when executed by the one or more processors individually or collectively, further cause the electronic device to:
perform the data embedding on the output data of the PA based on a basic envelope function, and
wherein the basic envelope function comprises at least one of a power series type basic envelope function or a Legendre type basic envelope function, based on a characteristic of the PA.

7. The electronic device of any one of claims 1 to 4, wherein the instructions, when executed by the one or more processors individually or collectively, further cause the electronic device to:
identify the estimated input data of the PA estimated based on the second DPD scheme by performing data embedding on the output data of the PA.

8. The electronic device of claim 7, wherein the instructions, when executed by the one or more processors individually or collectively, further cause the electronic device to:
perform the data embedding on the output data of the PA based on a basic envelope function, and
wherein the basic envelope function comprises at least one of a power series type basic envelope function or a Legendre type basic envelope function, based on a characteristic of the PA.

9. The electronic device of claim 7, wherein the instructions, when executed by the one or more processors individually or collectively, further cause the electronic device to:
perform the data embedding on the output data of the PA based on a magnitude of the output data of the PA, and a real value and an imaginary value of the output data of the PA.

10. The electronic device of any one of claims 1 to 9, wherein the GMP scheme is based on:
coefficients for data that is time-aligned with the input data of the PA and an envelope in a set time domain sample; and
a residual between the input data of the PA and the estimated input data of the PA estimated based on the first DPD scheme in the set time domain sample.

11. A method of an electronic device (101), the method comprising:
monitoring, during a set time period, input data of a power amplifier (PA) of the electronic device and output data of the PA;
identifying a weight value for a first digital pre-distortion (DPD) scheme which is based on a generalized memory polynomial (GMP) scheme, based on the input data of the PA and the output data of the PA;
identifying a hyperparameter for the second DPD scheme, based on estimated input data of the PA estimated based on a second DPD scheme which is based on a neural network (NN) scheme and estimated input data of the PA estimated based on the first DPD scheme, and the input data of the PA;
correcting first non-linear data included in the input data of the PA based on the weight value and the first DPD scheme, and
correcting second non-linear data included in the input data of the PA based on the hyperparameter and the second DPD scheme.

12. The method of claim 11, wherein the identifying the hyperparameter comprises:
identifying the hyperparameter that decreases a difference between the estimated input data of the PA estimated based on the second DPD scheme and the estimated input data of the PA estimated based on the first DPD scheme and the input data of the PA.

13. The method of claim 11, wherein the identifying the hyperparameter comprises:
identifying the hyperparameter that decreases a mean squared error (MSE) between the estimated input data of the PA estimated based on the second DPD scheme and the estimated input data of the PA estimated based on the first DPD scheme, and the input data of the PA.

14. The method of claim 11, wherein the identifying the hyperparameter comprises:
identifying the hyperparameter that decreases a residual between the input data of the PA and the estimated input data of the PA estimated based on the first DPD scheme.

15. The method of any one of claims 11 to 14, comprising:
identifying the estimated input data of the PA estimated based on the first DPD scheme by performing data embedding on the output data of the PA.
